# EUROPEAN PATENT APPLICATION

(11) **EP 4 672 899 A1**
(43) Date of publication of application: **31.12.2025**
(21) Application number: 24879727.6
(22) Date of filing: 16.10.2024
(51) Int. Cl.: H10D 30/01, H01L 21/66, H10D 8/50, H10D 12/00, H10D 30/66, H10D 62/10, H10D 84/80

(54) **METHOD FOR EVALUATING SEMICONDUCTOR SUBSTRATE AND METHOD FOR MANUFACTURING SEMICONDUCTOR DEVICE**

(30) Priority: 17.10.2023 JP 2023178973
(71) Applicant: Fuji Electric Co., Ltd., Kawasaki-shi, Kanagawa 210-9530 (JP)
(72) Inventor: IGUCHI, Kenichi, Kawasaki-shi, Kanagawa 210-9530 (JP); ISHIZAKI, Ryutaro, Kawasaki-shi, Kanagawa 210-9530 (JP)
(74) Representative: MERH-IP Matias Erny Reichl Hoffmann Patentanwälte PartG mbB
(86) International application number: PCT/JP2024/036784
(87) International publication number: WO 2025/084305

(57) **Abstract**

Provided is an evaluation method of a semiconductor substrate, including: implanting hydrogen ions from an implantation surface of a semiconductor substrate containing silicon; annealing the semiconductor substrate; measuring a differential carrier concentration, which is a difference between a first carrier concentration in a passage region of the semiconductor substrate through which the hydrogen ions have passed and a second carrier concentration in a non-passage region of the semiconductor substrate where the hydrogen ions have not reached; and evaluating a carbon concentration in the semiconductor substrate, based on the differential carrier concentration.

## Description

### BACKGROUND

### 1. TECHNICAL FIELD

The present invention relates to an evaluation method of a semiconductor substrate and a manufacturing method of a semiconductor device.

### 2. RELATED ART

A technique for forming a hydrogen donor by implanting hydrogen ions into a semiconductor substrate is known (see, for example, Patent Document 1).
Patent Document 1: Japanese Patent Application Publication No. 2018-195757

### (Technical Problem)

A concentration of the hydrogen donor to be formed by implanting the hydrogen ions varies depending on a carbon concentration of the semiconductor substrate. Therefore, it is preferable that the carbon concentration of the semiconductor substrate can be easily evaluated.

### GENERAL DISCLOSURE

In order to solve the problem described above, a first aspect of the present invention provides an evaluation method of a semiconductor substrate. In the evaluation method, hydrogen ions may be implanted from an implantation surface of a semiconductor substrate containing silicon. In any of the evaluation methods, the semiconductor substrate may be annealed. In any of the evaluation methods, a differential carrier concentration may be measured which is a difference between a first carrier concentration in a passage region of the semiconductor substrate through which the hydrogen ions have passed and a second carrier concentration in a non-passage region of the semiconductor substrate where the hydrogen ions have not reached. In any of the evaluation methods, a carbon concentration in the semiconductor substrate may be evaluated based on the differential carrier concentration.

In any of the evaluation methods, in the implanting the hydrogen ions, the hydrogen ions may be implanted into one or more implantation positions of the semiconductor substrate. In any of the evaluation methods, a dose amount of the hydrogen ions for at least one of the implantation positions may be 1×10¹¹/cm² or more.

In any of the evaluation methods, in the implanting the hydrogen ions, the hydrogen ions may be implanted into a first implantation position and a second implantation position closer to the implantation surface than the first implantation position. In any of the evaluation methods, in measurement of the first carrier concentration, a carrier concentration in a region between the first implantation position and the second implantation position may be measured.

In any of the evaluation methods, a dose amount of the hydrogen ions for the first implantation position may be identical to a dose amount of the hydrogen ions for the second implantation position.

In any of the evaluation methods, a dose amount of the hydrogen ions for the first implantation position may be larger than a dose amount of the hydrogen ions for the second implantation position.

In any of the evaluation methods, a dose amount of the hydrogen ions for the first implantation position may be smaller than a dose amount of the hydrogen ions for the second implantation position.

In any of the evaluation methods, after the annealing, a carrier concentration distribution in a depth direction of the semiconductor substrate may have a first concentration peak at the first implantation position. In any of the evaluation methods, a first distance between the first implantation position and the second implantation position may be 2 times or more and 10 times or less a first half width at half maximum at a portion of the first concentration peak on a side of the implantation surface.

In any of the evaluation methods, after the annealing, the carrier concentration distribution may have a second concentration peak at the second implantation position. In any of the evaluation methods, the first distance may be larger than a sum of the first half width at half maximum and a second half width at half maximum at a portion of the second concentration peak on a side opposite to the implantation surface.

In any of the evaluation methods, the second concentration peak may be in contact with the implantation surface.

In any of the evaluation methods, in the implanting the hydrogen ions, the hydrogen ions may be implanted into a third implantation position of the semiconductor substrate. In any of the evaluation methods, in measurement of the first carrier concentration, a carrier concentration in a region from the implantation surface to the third implantation position may be measured. In any of the evaluation methods, in measurement of the second carrier concentration, a carrier concentration in a region farther from the implantation surface than the third implantation position may be measured.

In any of the evaluation methods, after the annealing, a carrier concentration distribution in a depth direction of the semiconductor substrate may have a third concentration peak at the third implantation position. In any of the evaluation methods, in the measurement of the first carrier concentration, a carrier concentration may be measured at a position, which is a third half width at half maximum or more away from the third implantation position, in the passage region between the implantation surface and the third implantation position, the third half width at half maximum being in a portion of the third concentration peak on a side of the implantation surface.

In any of the evaluation methods, in the measurement of the first carrier concentration, a carrier concentration may be measured between the third implantation position and a center position between the implantation surface and the third implantation position.

In any of the evaluation methods, a distance between the implantation surface and the center position may be 2 times or more the third half width at half maximum.

In any of the evaluation methods, correlation information indicating a relationship between a carbon concentration of the semiconductor substrate and the differential carrier concentration may be acquired. In any of the evaluation methods, in the evaluating the carbon concentration, the carbon concentration may be calculated from the differential carrier concentration that is measured and the correlation information. In any of the evaluation methods, the semiconductor substrate may be an MCZ substrate.

A second aspect of the present invention provides a manufacturing method of a semiconductor device. In the manufacturing method, a carbon concentration of a semiconductor substrate for evaluation may be evaluated by using the evaluation method of the semiconductor substrate according to the first aspect. In any of the manufacturing methods, an implantation condition of ions to be implanted into a semiconductor substrate for manufacturing may be determined based on an evaluation result of the semiconductor substrate for evaluation. In any of the manufacturing methods, a semiconductor device may be manufactured by using the semiconductor substrate for manufacturing, based on the implantation condition that is determined.

The summary clause does not necessarily describe all necessary features of the embodiments of the present invention. In addition, the present invention may also be a sub-combination of the features described above.

### BRIEF DESCRIPTION OF THE DRAWINGS

Fig. 1 is a diagram for explaining a step of implanting hydrogen ions into a semiconductor substrate 10.
Fig. 2 is a diagram illustrating an example of a carrier concentration distribution along line A-A in Fig. 1.
Fig. 3 is a diagram illustrating a relationship between a differential carrier concentration ΔD and a carbon concentration of the semiconductor substrate 10.
Fig. 4 is a flowchart illustrating an example of a manufacturing method of a semiconductor device according to one embodiment of the present invention.
Fig. 5 is a diagram illustrating an example of a carrier concentration distribution and a hydrogen chemical concentration distribution in the semiconductor substrate 10 for evaluation.
Fig. 6 is an enlarged view of the carrier concentration distribution in a vicinity of a first implantation position I1 and a second implantation position I2.
Fig. 7 is a diagram illustrating another example of the carrier concentration distribution in the semiconductor substrate 10 for evaluation.
Fig. 8 is a diagram illustrating another example of the carrier concentration distribution in the semiconductor substrate 10 for evaluation.
Fig. 9 is a diagram illustrating correlation information 310 and a variation range of the correlation information 310 due to a measurement error of an SRP method.
Fig. 10 is a cross-sectional view illustrating an example of a semiconductor device 100 manufactured by using the semiconductor substrate 10 for manufacturing.

### DESCRIPTION OF EXEMPLARY EMBODIMENTS

Hereinafter, embodiments of the present invention will be described. However, the following embodiments are not for limiting the invention according to the claims. In addition, not all of the combinations of features described in the embodiments are essential to the solving means of the invention.

In the present specification, one side in a direction parallel to a depth direction of a semiconductor substrate is referred to as "upper" and another side is referred to as "lower". One surface of two principal surfaces of a substrate, a layer or other member is referred to as an upper surface, and another surface is referred to as a lower surface. "Upper" and "lower" directions are not limited to a direction of gravity, or a direction in which a semiconductor device is mounted.

In the present specification, technical matters may be described using orthogonal coordinate axes of an X axis, a Y axis, and a Z axis. The orthogonal coordinate axes merely specify relative positions of components, and do not limit a specific direction. For example, the Z axis is not limited to indicate a height direction with respect to a ground. Note that a +Z axis direction and a -Z axis direction are directions opposite to each other. When a Z axis direction is described without describing signs, it means that the direction is parallel to a +Z axis and a -Z axis.

In the present specification, orthogonal axes parallel to the upper surface and the lower surface of the semiconductor substrate are referred to as the X axis and the Y axis. In addition, an axis perpendicular to the upper surface and the lower surface of the semiconductor substrate is referred to as the Z axis. As used herein, a direction of the Z axis may be referred to as the depth direction. In addition, as used herein, a direction parallel to the upper surface and the lower surface of the semiconductor substrate may be referred to as a horizontal direction, including an X axis direction and a Y axis direction.

A region from a center of the semiconductor substrate in the depth direction to the upper surface of the semiconductor substrate may be referred to as an upper surface side. Similarly, a region from the center of the semiconductor substrate in the depth direction to the lower surface of the semiconductor substrate may be referred to as a lower surface side.

In the present specification, a case where a term such as "same" or "equal" is mentioned may include a case where an error due to a variation in manufacturing or the like is included. The error is, for example, within 10%.

In the present specification, a conductivity type of a doping region doped with impurities is described as a P type or an N type. As used herein, the impurities may particularly mean either a donor of the N type or an acceptor of the P type, and may be described as a dopant. As used herein, the doping means introducing the donor or the acceptor into the semiconductor substrate and turning it into a semiconductor presenting a conductivity type of the N type, or a semiconductor presenting a conductivity type of the P type.

In the present specification, a doping concentration means a concentration of the donor or a concentration of the acceptor in a thermal equilibrium state. As used herein, a net doping concentration means a net concentration obtained by adding the donor concentration set as a positive ion concentration to the acceptor concentration set as a negative ion concentration, taking into account of polarities of charges. As an example, when the donor concentration is N_{D} and the acceptor concentration is N_{A}, the net doping concentration at any position is given as N_{D}-N_{A}. As used herein, the net doping concentration may be simply described as the doping concentration.

The donor has a function of supplying electrons to the semiconductor. The acceptor has a function of receiving electrons from the semiconductor. The donor and acceptor are not limited to the impurities themselves. For example, a VOH defect in which a vacancy (V), oxygen (O), and hydrogen (H) present in the semiconductor are bonded together functions as the donor which supplies electrons. Alternatively, an interstitial Si-H defect in which interstitial silicon (Si-i) in a silicon semiconductor is bonded to hydrogen, and further a CiOi-H defect in which interstitial carbon is bonded to interstitial oxygen and hydrogen also function as a donor which supplies electrons. In the present specification, the VOH defect, the interstitial Si-H defect or the CiOi-H defect may be referred to as a hydrogen donor.

In the semiconductor substrate in the present specification, bulk donors of the N type are distributed throughout. The bulk donor is a dopant donor substantially uniformly contained in an ingot during manufacturing of the ingot from which the semiconductor substrate is made. The bulk donor in the present example is an element other than hydrogen. A dopant of the bulk donor is, for example, phosphorous, antimony, arsenic, selenium, or sulfur, but is not limited to these. The bulk donor in the present example is phosphorous. The bulk donor is also contained in a region of the P type. The semiconductor substrate may be a wafer cut out from a semiconductor ingot, or may be a chip obtained by singulating the wafer. The semiconductor ingot may be manufactured by any one of a Czochralski method (CZ method), a magnetic field applied Czochralski method (MCZ method), or a float zone method (FZ method). The ingot in the present example is manufactured by the MCZ method. The substrate manufactured by the MCZ method has an oxygen concentration of 1×10¹⁷ to 7×10¹⁷/cm³. The substrate manufactured by the FZ method has an oxygen concentration of 1×10¹⁵ to 5×10¹⁶/cm³. When the oxygen concentration is high, the hydrogen donor tends to be easily generated. A bulk donor concentration may use a chemical concentration of the bulk donors distributed throughout the semiconductor substrate, or may be a value between 90% and 100% of the chemical concentration. In addition, as the semiconductor substrate, a non-doped substrate not containing a dopant such as phosphorous may be used. In that case, a bulk donor concentration of the non-doped substrate is, for example, from 1×10¹⁰/cm³ or more and to 5×10¹²/cm³ or less. The bulk donor concentration of the non-doped substrate is preferably 1×10¹¹/cm³ or more. The bulk donor concentration of the non-doped substrate is preferably 5×10¹²/cm³ or less. Note that each concentration in the present invention may be a value at room temperature. As an example, a value at 300K (Kelvin) (about 26.9 degrees C) may be used as the value at room temperature.

In the present specification, a description of a P+ type or an N+ type means a higher doping concentration than that of the P type or the N type, and a description of a P- type or an N- type means a lower doping concentration than that of the P type or the N type. In addition, as used herein, a description of a P++ type or an N++ type means a higher doping concentration than that of the P+ type or the N+ type. As used herein, a unit system is an SI unit system unless otherwise noted. Although a unit of a length may be expressed in cm, various calculations may be performed after conversion to meters (m).

In the present specification, the chemical concentration refers to an atomic density of impurities measured regardless of an electrical activation state. The chemical concentration can be measured by, for example, secondary ion mass spectrometry (SIMS). The net doping concentration described above can be measured by capacitance-voltage profiling (CV method). In addition, a carrier concentration measured by spreading resistance profiling (SRP method) may be set as the net doping concentration. The carrier concentration measured by the CV method or the SRP method may be a value in a thermal equilibrium state. In addition, in a region of the N type, the donor concentration is sufficiently higher than the acceptor concentration, and thus the carrier concentration of the region may be defined as the donor concentration. Similarly, in a region of the P type, the carrier concentration of the region may be defined as the acceptor concentration. As used herein, the doping concentration of the region of the N type may be referred to as the donor concentration, and the doping concentration of the region of the P type may be referred to as the acceptor concentration.

When a concentration distribution of the donor, acceptor, or net doping has a peak in a region, a value of the peak may be defined as the concentration of the donor, acceptor, or net doping in the region. In a case where the concentration of the donor, acceptor, or net doping is substantially uniform in a region, or the like, an average value of the concentration of the donor, acceptor, or net doping in the region may be defined as the concentration of the donor, acceptor, or net doping. In the present specification, atoms/cm³ or /cm³ is used to express a concentration per unit volume. This unit is used for the donor or acceptor concentration or the chemical concentration in the semiconductor substrate. A notation of atoms may be omitted.

The carrier concentration measured by the SRP method may be lower than the concentration of the donor or the acceptor. In a range where a current flows when a spreading resistance is measured, carrier mobility of the semiconductor substrate may be lower than a value in a crystalline state. A decrease in carrier mobility occurs when carriers are scattered due to disorder of a crystal structure due to a lattice defect or the like.

The concentration of the donor or the acceptor calculated from the carrier concentration measured by the CV method or the SRP method may be lower than a chemical concentration of an element indicating the donor or the acceptor. As an example, in a silicon semiconductor, a donor concentration of phosphorous or arsenic serving as a donor, or an acceptor concentration of boron serving as an acceptor is about 99% of chemical concentrations of these. On the other hand, in the silicon semiconductor, a donor concentration of hydrogen serving as a donor is about 0.1% to 10% of a chemical concentration of hydrogen.

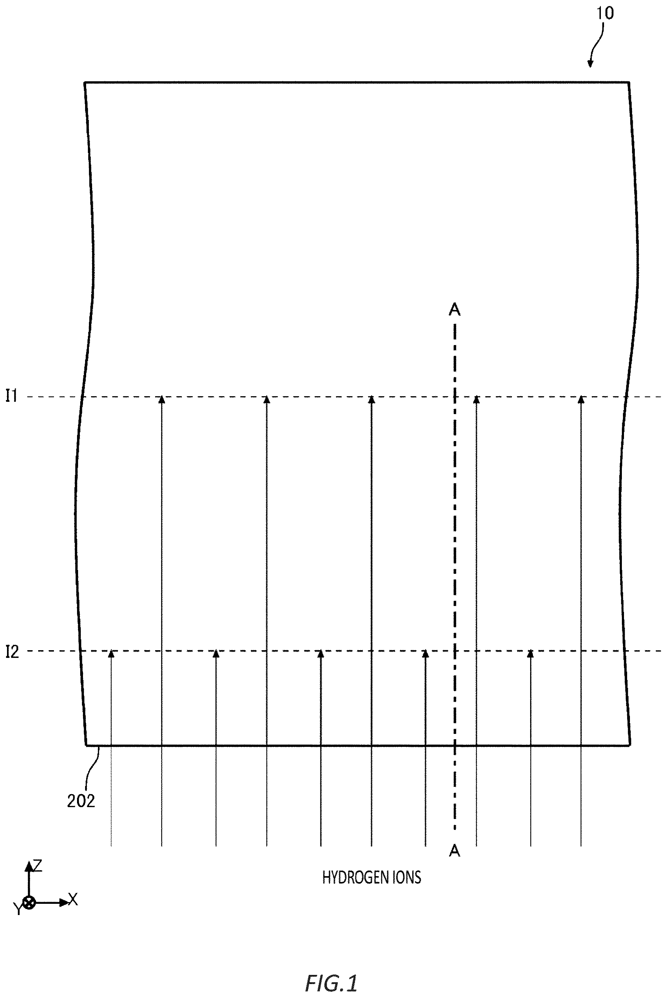

Fig. 1 is a diagram for explaining a step of implanting hydrogen ions into a semiconductor substrate 10. The semiconductor substrate 10 of the present example contains silicon. The semiconductor substrate 10 may be a silicon substrate. The semiconductor substrate 10 may contain a material other than silicon. The semiconductor substrate 10 may be a substrate used for manufacturing a semiconductor device. The semiconductor device includes a semiconductor element such as an insulated gate bipolar transistor (IGBT).

Fig. 1 illustrates a cross section of a partial region of the semiconductor substrate 10. The cross section is perpendicular to a principal surface of the semiconductor substrate 10. The principal surface of the semiconductor substrate 10 is a surface having a largest area among surfaces of the semiconductor substrate 10. The semiconductor substrate 10 of the present example has two principal surfaces perpendicular to the Z axis. The semiconductor substrate 10 may be in a state of a wafer cut out from an ingot or in a state of a chip cut out from a wafer.

In a manufacturing step of the semiconductor device, hydrogen ions such as protons may be implanted into the semiconductor substrate 10. Hydrogen donors are formed in the semiconductor substrate 10 by implanting hydrogen ions into the semiconductor substrate 10 and performing annealing. Accordingly, the donor concentration of the semiconductor substrate 10 can be locally or entirely adjusted.

For example, in a vertical power semiconductor device or the like, a field stop layer may be formed by the hydrogen donor. The field stop layer prevents a depletion layer widening from an upper surface side of the semiconductor substrate 10 from reaching a high concentration region such as a collector region provided on a lower surface side of the semiconductor substrate 10. In addition, a hydrogen donor may be formed in a part or a whole of the drift layer of the N type in the semiconductor substrate to adjust a donor concentration of the part or the whole of the drift layer. However, a region for forming the hydrogen donor is not limited to the above example.

In the example of Fig. 1, hydrogen ions are implanted into a first implantation position I1 and a second implantation position I2 from the implantation surface 202 of the semiconductor substrate 10. In the present example, hydrogen ions are implanted with acceleration energy corresponding to the first implantation position I1, and hydrogen ions are implanted with acceleration energy corresponding to the second implantation position I2. The second implantation position I2 is closer to the implantation surface 202 than the first implantation position I1. Note that implantation positions of hydrogen ions are not limited to two positions. The implantation positions of hydrogen ions may be one position or may be three positions or more. By annealing the semiconductor substrate 10 after implanting hydrogen ions, the implanted hydrogen ions are activated to form a hydrogen donor.

When hydrogen ions are implanted into the semiconductor substrate 10 by applying acceleration energy to the hydrogen ions, the hydrogen ions repeatedly collide with a crystal lattice of the semiconductor substrate 10 and enter an inside of the semiconductor substrate 10. As a result, many of the implanted hydrogen ions are distributed in a vicinity of the implantation position corresponding to the acceleration energy.

When sufficiently large energy is applied to silicon atoms at a lattice position of the semiconductor substrate 10 by the entered hydrogen ions, the silicon atoms move from the lattice position, and a lattice defect referred to as a vacancy and interstitial Si is generated. Many of the implanted hydrogen ions stop in the vicinity of the implantation position corresponding to the acceleration energy. On the other hand, some of the hydrogen ions stop in a passage region shallower than the implantation position for a reason that a movement direction changes due to scattering, or the like. The passage region is a region from the implantation surface 202 to the implantation position.

Hydrogen ions have high reactivity, and are easily bonded to vacancies, interstitial Si, oxygen, or the like. Depending on bonding states between hydrogen ions and lattice defects, oxygen, or the like, these bonds may form donor levels or recombination levels. When these bonds form donor levels, they function as hydrogen donors. In addition, when these bonds form recombination levels, they function as lifetime killers. However, a concentration of the hydrogen donor to be formed varies depending on a carbon concentration in the semiconductor substrate 10.

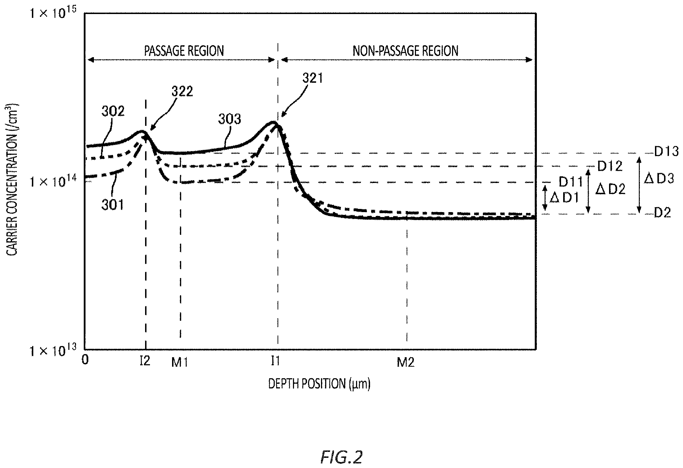

Fig. 2 is a diagram illustrating an example of a carrier concentration distribution along line A-A in Fig. 1. The line A-A is a line passing through the first implantation position I1 and the second implantation position I2 and parallel to the Z axis. An origin 0 of a horizontal axis is a position of the implantation surface 202. Fig. 2 illustrates carrier concentration distribution 301, carrier concentration distribution 302, and carrier concentration distribution 303 measured for semiconductor substrates 10 having a same resistivity and different carbon concentrations. The carrier concentration distribution 303 is a distribution of a sample in which the semiconductor substrate 10 has a highest carbon concentration, the carrier concentration distribution 302 is a distribution of a sample in which the semiconductor substrate 10 has a second highest carbon concentration, and the carrier concentration distribution 301 is a distribution of a sample in which the semiconductor substrate 10 has a lowest carbon concentration. In each example, conditions other than the carbon concentration (for example, the implantation position and a dose amount of hydrogen ions) are the same.

A region from the implantation surface 202 (depth position of 0 µm) to the implantation position of hydrogen ions is referred to as a passage region of hydrogen ions. When there are a plurality of implantation positions, a region between the implantation position farthest from the implantation surface 202 and the implantation surface 202 is referred to as the passage region. In the example of Fig. 2, a region from the implantation surface 202 to the first implantation position I1 is the passage region. A region through which hydrogen ions do not pass is referred to as a non-passage region. A region farther from the implantation surface 202 than the implantation position may be referred to as the non-passage region. When there are a plurality of implantation positions, a region farther from the implantation surface 202 than the implantation position farthest from the implantation surface 202 is referred to as the non-passage region. In the example of Fig. 2, a region farther from the implantation surface 202 than the first implantation position I1 is the non-passage region. In the non-passage region, hydrogen ions may be present in a region in contact with the passage region.

After hydrogen ions are implanted, the semiconductor substrate 10 is annealed. Accordingly, in the carrier concentration distribution in the depth direction, a concentration peak is formed at the implantation position of hydrogen ions. In each example of Fig. 2, a first concentration peak 321 is formed at the first implantation position I1, and a second concentration peak 322 is formed at the second implantation position I2. A position of a local maximum of the concentration peak of the carrier concentration may be regarded as the implantation position of hydrogen ions.

As described above, hydrogen ions stop also in the passage region other than the vicinity of the implantation position, and a hydrogen donor is formed. Therefore, a carrier concentration of the passage region other than the vicinity of the implantation position is also higher than a carrier concentration of the non-passage region. In the present example, the carrier concentration of the non-passage region is defined as D2. The carrier concentration D2 may be a minimum value of the carrier concentration in a region where a pn junction is not formed in the non-passage region. As the carrier concentration D2, a bulk donor concentration may be used. A carrier concentration at a measurement position M2 separated by a predetermined distance from the implantation position farthest from the implantation surface 202 (the first implantation position I1 in the present example) to a side opposite to the implantation surface 202 may be set as the carrier concentration D2. The predetermined distance may be 10 µm or more, 20 µm or more, or 30 µm or more.

As illustrated in Fig. 2, a carrier concentration of the passage region changes according to the carbon concentration in the semiconductor substrate 10. The carrier concentration of the passage region is mainly caused by a concentration of CiOi-H. In particular, a carrier concentration of a region away from the implantation position in the passage region greatly changes according to the carbon concentration. On the other hand, the carrier concentration D2 of the non-passage region is substantially constant regardless of the carbon concentration in the semiconductor substrate 10.

As illustrated in Fig. 2, as the carbon concentration of the semiconductor substrate 10 increases, the carrier concentration of the passage region increases. It is considered that the increase in the carbon concentration increases the concentration of CiOi-H. In the carrier concentration distributions 301, 302, and 303, carrier concentrations at a measurement position M1 in the passage region are defined as D11, D12, and D13, respectively. The measurement position M1 of the present example is arranged between the first implantation position I1 and the second implantation position I2. The measurement position M1 may be a depth position where the carrier concentration becomes a local minimum value, between the first implantation position I1 and the second implantation position I2.

The carrier concentration D2 of the non-passage region is substantially constant regardless of the carbon concentration of the semiconductor substrate 10. In contrast, the carrier concentrations D11, D12, and D13 in the passage region change according to the carbon concentration of the semiconductor substrate 10. Therefore, differential carrier concentrations ΔD1, ΔD2, and ΔD3, which are differences between the carrier concentration D2 in the non-passage region and the carrier concentrations D11, D12, and D13 in the passage region, also change according to the carbon concentration of the semiconductor substrate 10.

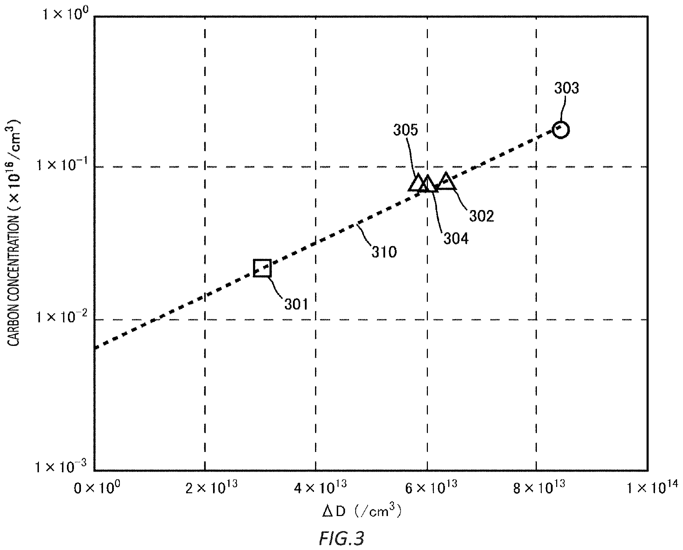

Fig. 3 is a diagram illustrating a relationship between a differential carrier concentration ΔD and the carbon concentration of the semiconductor substrate 10. In Fig. 3, a sample corresponding to the carrier concentration distribution 303 is plotted by a circle, a sample corresponding to the carrier concentration distribution 302 is plotted by a triangle, and a sample corresponding to the carrier concentration distribution 301 is plotted by a square. As illustrated in Fig. 3, the differential carrier concentration ΔD increases as the carbon concentration of the semiconductor substrate 10 increases.

By acquiring in advance correlation information 310 indicating a relationship between the carbon concentration of the semiconductor substrate 10 and the differential carrier concentration ΔD as illustrated in Fig. 3, the carbon concentration of the semiconductor substrate 10 can be evaluated from the differential carrier concentration of the semiconductor substrate 10. The correlation information 310 may be information indicated by a straight line in a graph in which the carbon concentration of the semiconductor substrate 10 is shown on a logarithmic axis and the differential carrier concentration ΔD is shown on a linear axis.

Fig. 3 illustrates a sample 304 and a sample 305 in which the carbon concentration of the semiconductor substrate 10 is substantially the same as that of the sample of the carrier concentration distribution 302 and a dose amount of hydrogen ions is changed. In the sample 304, the dose amount (/cm²) of hydrogen ions is one-third that of the sample of the carrier concentration distribution 302. In the sample 305, the dose amount (/cm²) of hydrogen ions is 3 times that of the sample of the carrier concentration distribution 302. As illustrated in Fig. 3, even when the dose amount of hydrogen ions is changed from one-third to 3 times, a variation in the differential carrier concentration ΔD is about ±5%, which is sufficiently small. Therefore, even when the dose amount of hydrogen ions changes, the carbon concentration of the semiconductor substrate 10 can be evaluated from the differential carrier concentration by using the correlation information 310, which is common. In particular, the carbon concentration of the semiconductor substrate 10 can be evaluated for the carbon concentration of 1×10¹⁶/cm³ or less, down to an order of about 1×10¹⁴/cm³.

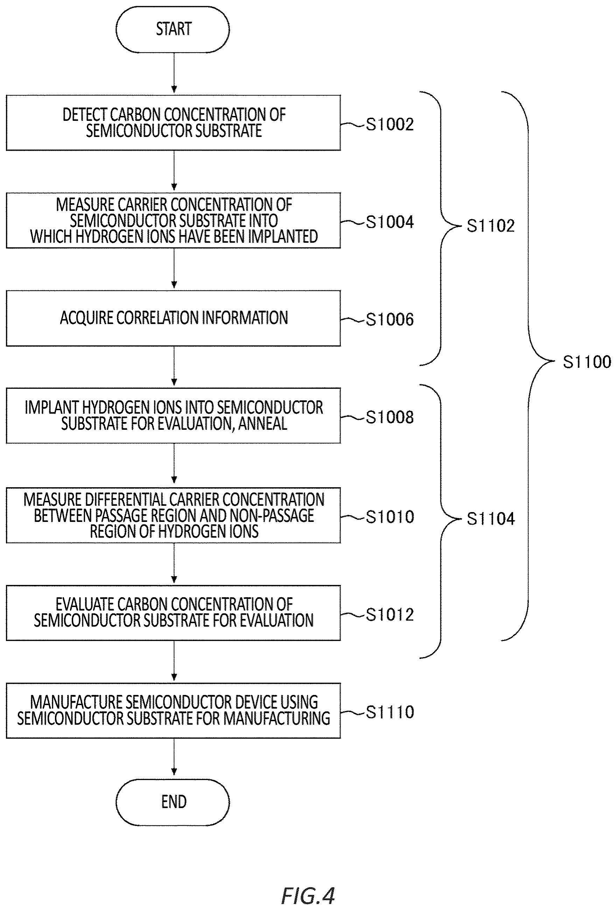

Fig. 4 is a flowchart illustrating an example of a manufacturing method of a semiconductor device according to one embodiment of the present invention. The manufacturing method includes an evaluation method S1100 of evaluating the semiconductor substrate 10. The manufacturing method includes a manufacturing step S1110 based on an evaluation result by the evaluation method S1100.

The evaluation method S1100 of the present example includes a preparation step S1102 and an evaluation step S1104. In the preparation step S1102, the correlation information 310 as described in Fig. 3 is acquired. The preparation step S1102 in the present example includes a carbon concentration detection step S1002, a carrier concentration measurement step S1004, and a correlation information acquisition step S1006.

In the carbon concentration detection step S1002, the carbon concentration is detected for a plurality of semiconductor substrates 10 having different carbon concentrations. In S1002, the carbon concentration is detected by a known method such as SIMS, low-temperature Fourier transform infrared spectroscopy (FT-IR), or deep level transient spectrometer (DLTS).

In the carrier concentration measurement step S1004, the differential carrier concentration is measured for the plurality of semiconductor substrates 10 into which hydrogen ions have been implanted. In the carrier concentration measurement step S1004, as described in Fig. 2, a difference in carrier concentration between the measurement positions M1 and M2 is measured.

In S1002 and S1004, the carbon concentration and the differential carrier concentration of the same semiconductor substrate 10 are measured. Either of S1002 and S1004 may be performed first. In each of the semiconductor substrates 10, hydrogen ion implantation conditions such as the dose amount of hydrogen ions, acceleration energy, and a number of at least one implantation position may be the same or different. In one semiconductor substrate 10, the dose amount of hydrogen ions for at least one implantation position is, for example, 1×10¹¹/cm² or more and 5×10¹⁵/cm² or less. The dose amount may be 3×10¹¹/cm² or more, or 5×10¹²/cm² or more. The dose amount may be 1×10¹⁵/cm² or less, or 1×10¹⁴/cm² or less. The dose amounts for all implantation positions may be included in any range of the dose amount described above.

In the correlation information acquisition step S1006, the correlation information 310 indicating a relationship between the differential carrier concentration and the carbon concentration is acquired based on measurement results in S1002 and S1004. In the correlation information acquisition step S1006, the correlation information 310 may be calculated by plotting the measurement results of the plurality of semiconductor substrates 10 as illustrated in Fig. 3 to calculate an approximate line. The correlation information 310 may be an expression indicating the relationship between the differential carrier concentration and the carbon concentration, may be a table indicating the relationship, or may be information in another format.

In the preparation step S1102, a plurality of types of correlation information 310 may be acquired corresponding to a plurality of types of the semiconductor substrate 10. The semiconductor substrate 10 may be classified into a plurality of types according to an oxygen concentration in the semiconductor substrate 10. For example, a range of the oxygen concentration is set in advance for each type, and the semiconductor substrate 10 is classified according to which oxygen concentration range the oxygen concentration of the semiconductor substrate 10 belongs. The semiconductor substrate 10 may be classified into a plurality of types according to a manufacturing method of the semiconductor substrate 10. For example, the semiconductor substrate 10 may be classified into types such as an FZ substrate, a CZ substrate, and an MCZ substrate. The semiconductor substrate 10 may be classified into a plurality of types according to a dose amount of hydrogen ions implanted into the semiconductor substrate 10.

In the evaluation step S1104, the carbon concentration of the semiconductor substrate 10 for evaluation is evaluated based on the differential carrier concentration in the semiconductor substrate 10 for evaluation. The semiconductor substrate 10 for evaluation is separate from the semiconductor substrate 10 measured in the preparation step S1102. The semiconductor substrate 10 for evaluation may be separate from the semiconductor substrate 10 for manufacturing described below. The semiconductor substrate 10 for evaluation may be of a same type as the semiconductor substrate 10 for manufacturing. The semiconductor substrate 10 for evaluation may be from a same lot as the semiconductor substrate 10 for manufacturing.

The evaluation step S1104 in the present example has a hydrogen ion implantation step S1008, a differential carrier concentration measurement step S1010, and a carbon concentration evaluation step S1012. In the hydrogen ion implantation step S1008, hydrogen ions are implanted from the implantation surface 202 of the semiconductor substrate 10 for evaluation. In the hydrogen ion implantation step S1008, hydrogen ions are implanted into one or more implantation positions. In the hydrogen ion implantation step S1008, hydrogen ions may be implanted into two or more implantation positions.

The dose amount of hydrogen ions for at least one implantation position is, for example, 1×10¹¹/cm² or more and 5×10¹⁵/cm² or less. The dose amount may be 3×10¹¹/cm² or more, or 5×10¹¹/cm² or more. The dose amount may be 1×10¹⁵/cm² or less, or 1×10¹⁴/cm² or less. The dose amounts for all implantation positions may be included in any range of the dose amount described above.

In the hydrogen ion implantation step S1008, after hydrogen ions are implanted, the semiconductor substrate 10 is annealed. A temperature and time of annealing in S1008 may be the same as or different from a temperature and time of annealing performed after hydrogen ions are implanted into the semiconductor substrate 10 for manufacturing. By annealing the semiconductor substrate 10, a hydrogen donor is formed in the passage region as in each sample illustrated in Fig. 2.

In the differential carrier concentration measurement step S1010, the differential carrier concentration ΔD, which is a difference between a first carrier concentration D1 in the passage region of hydrogen ions and a second carrier concentration D2 in the non-passage region where hydrogen ions have not reached, is measured. A measurement position of the second carrier concentration D2 is similar to the measurement position M2 in the example of Fig. 2. A measurement position of the first carrier concentration D1 is similar to the measurement position M1 in the example of Fig. 2. In the differential carrier concentration measurement step S1010, the carrier concentration distribution in the depth direction as illustrated in Fig. 2 may be measured. Various carrier concentrations described in the present specification may be measured by the SRP method. Compared to the SIMS method, the SRP method can measure lower concentrations with higher accuracy.

In the carbon concentration evaluation step S1012, the carbon concentration in the semiconductor substrate 10 for evaluation is evaluated based on the differential carrier concentration ΔD. In the carbon concentration evaluation step S1012 of the present example, the carbon concentration corresponding to the differential carrier concentration ΔD is estimated with reference to the correlation information 310 acquired in advance. In S1012, the correlation information 310 corresponding to a type of the semiconductor substrate 10 for evaluation may be used.

In the manufacturing step S1110, an implantation condition of ions to be implanted into the semiconductor substrate 10 for manufacturing is determined based on an evaluation result (that is, the estimated carbon concentration) of the semiconductor substrate 10 for evaluation in the carbon concentration evaluation step S1012. The implantation condition may include at least one of a dose amount, a depth position of each implantation position, or a number of at least one implantation position.

In the manufacturing step S1110, an implantation condition of hydrogen ions to be implanted into the semiconductor substrate 10 for manufacturing may be determined. The hydrogen ions are implanted to form a hydrogen donor. For example, when the carbon concentration of the semiconductor substrate 10 for evaluation is lower than expected, an integrated concentration of the doping concentration from the implantation surface 202 to a hydrogen ion implantation depth may be adjusted by making a dose amount of hydrogen ions implanted into the semiconductor substrate 10 for manufacturing larger than an initial design value to increase a peak concentration at a peak position of hydrogen ions. Alternatively, the integrated concentration of the doping concentration from the implantation surface 202 to the hydrogen ion implantation depth may be adjusted by increasing a distance from the implantation surface 202 to the peak position of hydrogen ions. Conversely, when the carbon concentration of the semiconductor substrate 10 for evaluation is higher than expected, the integrated concentration of the doping concentration from the implantation surface 202 to the hydrogen ion implantation depth may be adjusted by making the dose amount of hydrogen ions implanted into the semiconductor substrate 10 for manufacturing smaller than the initial design value to lower the peak concentration at the peak position of hydrogen ions. Alternatively, the integrated concentration of the doping concentration from the implantation surface 202 to the hydrogen ion implantation depth may be adjusted by reducing the distance from the implantation surface 202 to the peak position of hydrogen ions. Accordingly, it is possible to reduce a variation in the concentration of the hydrogen donor due to a variation in the carbon concentration.

In the manufacturing step S1110, an implantation condition of ions for lifetime killer formation may be determined. The ions is, for example, helium ions. A density of lifetime killers (for example, recombination levels) formed when helium ions or the like are implanted varies depending on the carbon concentration of the semiconductor substrate 10. In the manufacturing step S1110, a dose amount of ions for lifetime killer formation may be adjusted according to the carbon concentration of the semiconductor substrate 10.

In the manufacturing step S1110, a semiconductor device is manufactured based on the determined implantation condition of ions by using the semiconductor substrate 10 for manufacturing. The semiconductor device includes, for example, a power semiconductor element such as an IGBT.

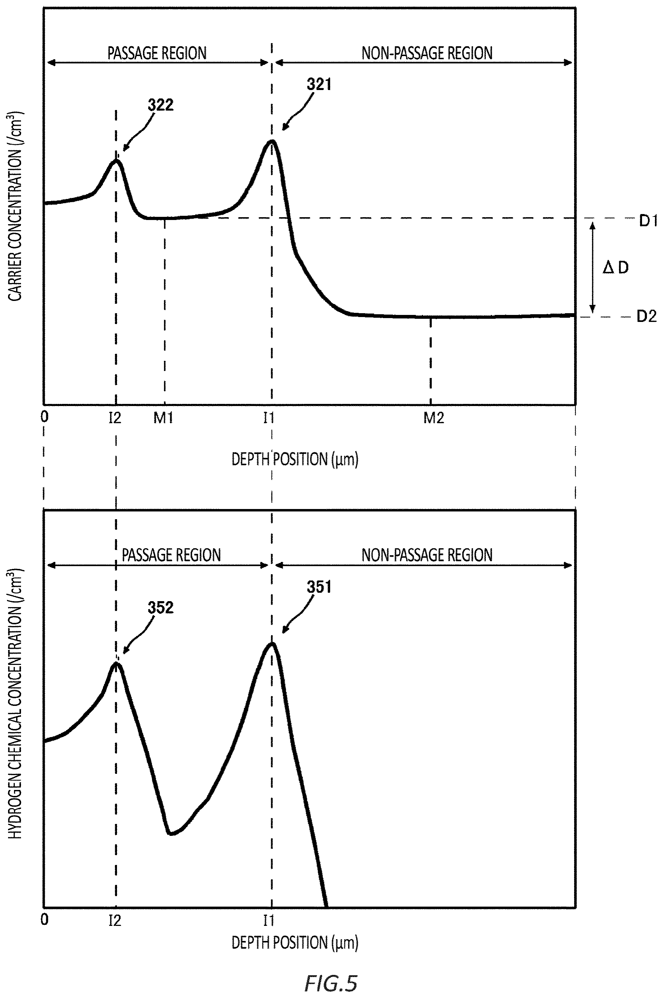

Fig. 5 is a diagram illustrating an example of a carrier concentration distribution and a hydrogen chemical concentration distribution in the semiconductor substrate 10 for evaluation. Fig. 5 illustrates each distribution after annealing in the hydrogen ion implantation step S1008. In the present example, hydrogen ions are implanted into the first implantation position I1 and the second implantation position I2 of the semiconductor substrate 10 for evaluation. The second implantation position I2 is closer to the implantation surface 202 than the first implantation position I1. An implantation position and a dose amount of hydrogen ions with respect to the semiconductor substrate 10 for evaluation may be similar to those in the example of Fig. 2. As illustrated in Fig. 5, the hydrogen chemical concentration distribution has a peak 351 and a peak 352 of a hydrogen chemical concentration at the first implantation position I1 and the second implantation position I2.

In the differential carrier concentration measurement step S1010, the differential carrier concentration ΔD, which is a difference between the first carrier concentration D1 in the passage region of hydrogen ions and the second carrier concentration D2 in the non-passage region where hydrogen ions have not reached, is measured. In the present example, the first carrier concentration D1 is measured at the measurement position M1 in a region between the first implantation position I1 and the second implantation position I2. In addition, the second carrier concentration D2 is measured at the measurement position M2 farther from the implantation surface 202 than the first implantation position I1. Each measurement position may be similar to that of the example of Fig. 2. The carrier concentration in the passage region may have a flat region where the carrier concentration distribution is relatively flat, between the first concentration peak 321 and the second concentration peak 322. On the other hand, the hydrogen chemical concentration in the passage region may have a valley where the hydrogen chemical concentration distribution does not include a flat region, between the peak 351 and the peak 352 of the hydrogen chemical concentration. Since the carrier concentration distribution reflects the concentration of CiOi-H, there is an effect of improving a measurement accuracy of the carbon concentration.

By arranging the first implantation position I1 and the second implantation position I2 with the measurement position M1 interposed therebetween, it is possible to reduce a measurement error of the first carrier concentration D1 due to a variation in the measurement position M1. For example, when hydrogen ions are not implanted into the second implantation position I2, the carrier concentration continuously decreases from the first implantation position I1 toward the implantation surface 202. Therefore, the first carrier concentration D1 varies depending on where the measurement position M1 is set.

In the present example, hydrogen ions are also implanted into the second implantation position I2. Therefore, the carrier concentration shows a local minimum value between the first implantation position I1 and the second implantation position I2. By arranging the measurement position M1 in a vicinity of a depth position indicating the local minimum value, it is possible to suppress a variation in the first carrier concentration D1.

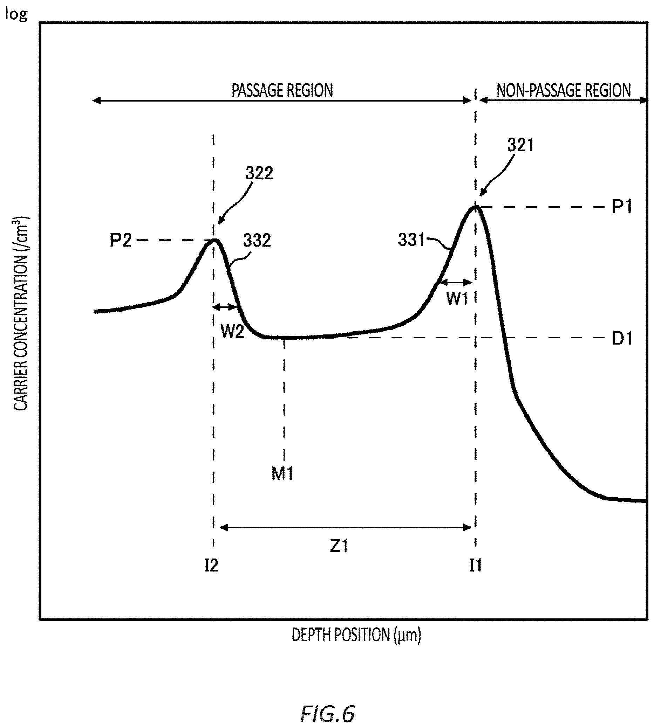

Fig. 6 is an enlarged view of the carrier concentration distribution in a vicinity of the first implantation position I1 and the second implantation position I2. A carrier concentration at a local maximum of the first concentration peak 321 is defined as P1, and a carrier concentration at a local maximum of the second concentration peak 322 is defined as P2.

A dose amount of hydrogen ions for the first implantation position I1 and a dose amount of hydrogen ions for the second implantation position I2 may be the same. The carrier concentration P1 and the carrier concentration P2 may be the same.

The dose amount of hydrogen ions for the first implantation position I1 may be larger than the dose amount of hydrogen ions for the second implantation position I2. As illustrated in Fig. 6, the carrier concentration P1 may be higher than the carrier concentration P2. It is sufficient if, in the dose amount of hydrogen ions for the second implantation position I2, the local minimum value of the carrier concentration can be formed between the first implantation position I1 and the second implantation position I2. The carrier concentration P2 may be 2 times or more, 5 times or more, or 10 times or more the local minimum value.

The dose amount of hydrogen ions for the first implantation position I1 may be smaller than the dose amount of hydrogen ions for the second implantation position I2. The carrier concentration P1 may be lower than the carrier concentration P2.

The first concentration peak 321 has a portion 331 which is arranged on the implantation surface 202 side with respect to the first implantation position I1. A half width at half maximum in the portion 331 of the first concentration peak 321 is referred to as a first half width at half maximum W1. The first half width at half maximum W1 is a distance from a depth position where the carrier concentration is half of P1 in the portion 331 to the first implantation position I1.

The second concentration peak 322 has a portion 332 which is arranged on a side opposite to the implantation surface 202 with respect to the second implantation position I1. A half width at half maximum in the portion 332 of the second concentration peak 322 is referred to as a second half width at half maximum W2. The second half width at half maximum W2 is a distance from a depth position where the carrier concentration is half of P2 in the portion 332 to the second implantation position I2.

A distance between the first implantation position I1 and the second implantation position I2 is referred to as a first distance Z1. The first distance Z1 may be 2 times or more the first half width at half maximum W1. Accordingly, it becomes easy to create a region where the carrier concentration gently changes, between the first implantation position I1 and the second implantation position I2. The first distance Z1 may be 3 times or more or 4 times or more the first half width at half maximum W1.

The first distance Z1 may be 10 times or less the first half width at half maximum W1. Accordingly, the first implantation position I1 does not need to be set too far apart. Therefore, it is possible to suppress the acceleration energy of hydrogen ions from becoming excessively large, and it is possible to reduce a cost of a hydrogen ion implantation device. The first distance Z1 may be 9 times or less or 7 times or less the first half width at half maximum W1.

The first distance Z1 may be larger than a sum W1+W2 of the first half width at half maximum W1 and the second half width at half maximum W2. Accordingly, it becomes easy to create a region where the carrier concentration gently changes, between the first implantation position I1 and the second implantation position I2. The first distance Z1 may be 1.5 times or more, 2 times or more, or 3 times or more the sum W1+W2 of the half widths at half maximum. The first distance Z1 may be 20 times or less, 15 times or less, or 10 times or less the sum W1+W2 of the half widths at half maximum.

The first distance Z1 may be 2 times or more the second half width at half maximum W2. Accordingly, it becomes easy to create a region where the carrier concentration gently changes, between the first implantation position I1 and the second implantation position I2. The first distance Z1 may be 3 times or more or 4 times or more the second half width at half maximum W2. The first distance Z1 may be 10 times or less the second half width at half maximum W2. The first distance Z1 may be 9 times or less or 7 times or less the second half width at half maximum W2.

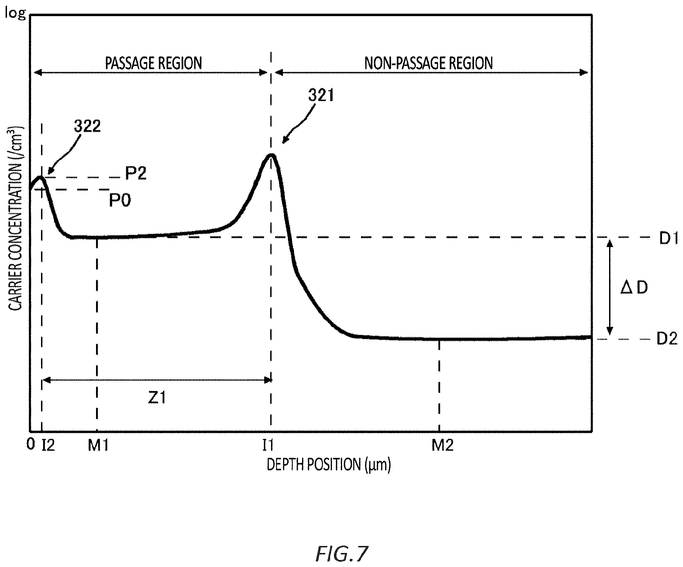

Fig. 7 is a diagram illustrating another example of the carrier concentration distribution in the semiconductor substrate 10 for evaluation. The first distance Z1 between the first implantation position I1 and the second implantation position I2 is similar to that of the example described in Fig. 6.

In the present example, the second concentration peak 322 in the carrier concentration distribution is in contact with the implantation surface 202. The second concentration peak 322 being in contact with the implantation surface 202 means that a carrier concentration P0 at the implantation surface 202 is half or more of the carrier concentration P2. According to the present example, the first implantation position I1 can be made shallow while securing the first distance Z1. Therefore, the cost of the hydrogen ion implantation device can be reduced.

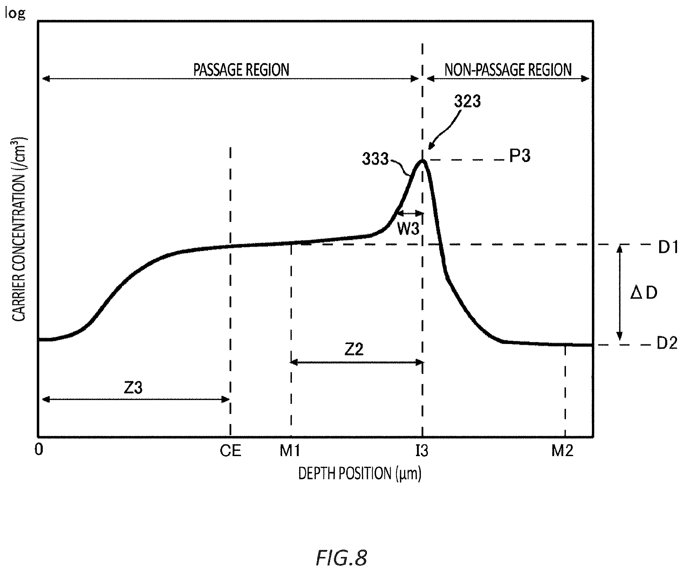

Fig. 8 is a diagram illustrating another example of the carrier concentration distribution in the semiconductor substrate 10 for evaluation. In the present example, in the hydrogen ion implantation step S1008, hydrogen ions are implanted into only one implantation position. The implantation position of hydrogen ions in the present example is referred to as a third implantation position I3.

In the present example, the first carrier concentration D1 is measured in a region from the implantation surface 202 to the third implantation position I3. In addition, the second carrier concentration D2 is measured in a region farther from the implantation surface 202 than the third implantation position I3. The measurement position M2 of the second carrier concentration D2 is similar to that of the example of Fig. 2.

The carrier concentration distribution in the present example has a third concentration peak 323 at the third implantation position I3. A carrier concentration at a local maximum of the third concentration peak 323 is defined as P3. The third concentration peak 323 has a portion 333 which is arranged on the implantation surface 202 side with respect to the third implantation position I3. A half width at half maximum in the portion 333 of the third concentration peak 323 is referred to as a third half width at half maximum W3. The third half width at half maximum W3 is a distance from a depth position where the carrier concentration is half of P3 in the portion 333 to the third implantation position I3.

The measurement position M1 of the present example is the third half width at half maximum W3 or more away from the third implantation position I3 in the passage region between the implantation surface 202 and the third implantation position I3. A distance between the measurement position M1 and the third implantation position I3 is referred to as a second distance Z2. The second distance Z2 may be 2 times or more the third half width at half maximum W3. Accordingly, the first carrier concentration D1 can be measured in a region where the carrier concentration gently changes. The second distance Z2 may be 3 times or more or 4 times or more the third half width at half maximum W3.

In the present example, the second concentration peak 322 is not provided. Therefore, when approaching the implantation surface 202, the carrier concentration may sharply decrease. In particular, in a vicinity of the implantation surface 202, hydrogen may be released to an outside of the semiconductor substrate 10, and the concentration of hydrogen donors may decrease. The second distance Z2 may be 10 times or less or 8 times or less the third half width at half maximum W3.

A center position of the passage region in the depth direction is defined as CE. A distance from the implantation surface 202 to the center position CE is half of a distance from the implantation surface 202 to the third implantation position I3. The measurement position M1 may be arranged between the center position CE and the third implantation position I3.

The distance from the implantation surface 202 to the center position CE is referred to as a third distance Z3. The third distance Z3 may be 2 times or more the third half width at half maximum W3. The third distance Z3 may be 3 times or more, 5 times or more, or 10 times or more the third half width at half maximum W3. By preventing the measurement position M1 from being excessively close to the implantation surface 202, the first carrier concentration D1 can be measured in a region where the carrier concentration gently changes.

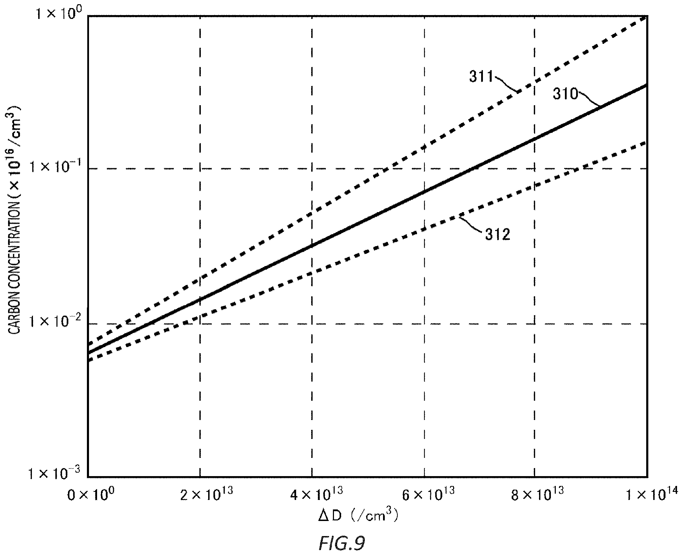

Fig. 9 is a diagram illustrating the correlation information 310 and a variation range of the correlation information 310 due to a measurement error of the SRP method. In the present example, the measurement error of the SRP method is estimated to be ±20%. A straight line 311 corresponds to a case where the measurement error is +20%, and indicates an upper limit of the variation range of the correlation information 310. A straight line 312 corresponds to a case where the measurement error is -20%, and indicates a lower limit of the variation range of the correlation information 310.

As illustrated in Fig. 9, in a region where the carbon concentration of the semiconductor substrate 10 is low or the differential carrier concentration ΔD is small, a variation in the correlation information 310 due to the measurement error of the SRP method becomes small. For example, when the carbon concentration of the semiconductor substrate 10 is 1×10¹⁵/cm³ or less, the carbon concentration of the semiconductor substrate 10 can be accurately measured from the differential carrier concentration ΔD by using the correlation information 310. In an existing method such as the SIMS method, it is difficult to easily and accurately measure a carbon concentration of 1×10¹⁵/cm³ or less, for example.

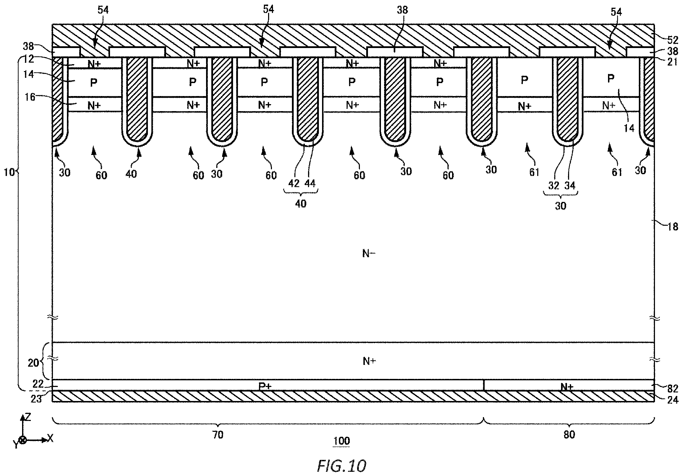

Fig. 10 is a cross-sectional view illustrating an example of a semiconductor device 100 manufactured by using the semiconductor substrate 10 for manufacturing. In the cross section, the semiconductor device 100 of the present example includes the semiconductor substrate 10, an interlayer dielectric film 38, the emitter electrode 52, and a collector electrode 24. The semiconductor substrate 10 of the present example is provided with a transistor portion 70 such as an IGBT and a diode portion 80 such as a freewheeling diode. The semiconductor substrate 10 has an upper surface 21 and a lower surface 23.

The interlayer dielectric film 38 is provided on the upper surface 21 of the semiconductor substrate 10. The interlayer dielectric film 38 is a film including at least one layer of a dielectric film such as silicate glass to which impurities such as boron or phosphorous are added, a thermal oxide film, or other dielectric films. The interlayer dielectric film 38 is provided with a contact hole 54.

The emitter electrode 52 is provided above the interlayer dielectric film 38. The emitter electrode 52 is in contact with the upper surface 21 of the semiconductor substrate 10 through the contact hole 54 of the interlayer dielectric film 38. The collector electrode 24 is provided on the lower surface 23 of the semiconductor substrate 10. The emitter electrode 52 and the collector electrode 24 are formed of a metal material such as aluminum. In the present specification, a direction in which the emitter electrode 52 is connected to the collector electrode 24 (Z axis direction) is referred to as the depth direction.

The semiconductor substrate 10 includes a drift region 18 of the N type or the N- type. The drift region 18 is provided in each of the transistor portion 70 and the diode portion 80.

In the mesa portion 60 of the transistor portion 70, the emitter region 12 of the N+ type and the base region 14 of the P- type are provided in order from the upper surface 21 side of the semiconductor substrate 10. The mesa portion is a region sandwiched between two trench portions. The drift region 18 is provided below the base region 14. The mesa portion 60 may be provided with an accumulation region 16 of the N+ type. The accumulation region 16 is arranged between the base region 14 and the drift region 18.

The emitter region 12 is exposed on the upper surface 21 of the semiconductor substrate 10 and is provided in contact with the gate trench portion 40. The emitter region 12 may be in contact with the trench portions on both sides of the mesa portion 60. The emitter region 12 has a higher doping concentration than the drift region 18.

The base region 14 is provided below the emitter region 12. The base region 14 of the present example is provided in contact with the emitter region 12. The base region 14 may be in contact with the trench portions on both sides of the mesa portion 60.

The accumulation region 16 is provided below the base region 14. The accumulation region 16 is a region of the N+ type having a higher doping concentration than the drift region 18. That is, the accumulation region 16 has a higher donor concentration than the drift region 18. Providing the accumulation region 16, which has a high concentration, between the drift region 18 and the base region 14 can increase a carrier implantation enhancement effect (IE effect) and reduce an on-voltage. The accumulation region 16 may be provided so as to cover an entire lower surface of the base region 14 in each mesa portion 60.

The mesa portion 61 of the diode portion 80 is provided with the base region 14 of the P-type in contact with the upper surface 21 of the semiconductor substrate 10. The drift region 18 is provided below the base region 14. In the mesa portion 61, the accumulation region 16 may be provided below the base region 14.

In each of the transistor portion 70 and the diode portion 80, a buffer region 20 of the N+ type may be provided below the drift region 18. A doping concentration of the buffer region 20 is higher than the doping concentration of the drift region 18. The buffer region 20 may function as a field stop layer which prevents a depletion layer widening from a lower end of the base region 14 from reaching the collector region 22 of the P+ type and the cathode region 82 of the N+ type.

The buffer region 20 may have a concentration peak having a higher doping concentration than the drift region 18. A doping concentration at a concentration peak refers to a doping concentration at a local maximum of the concentration peak. In addition, as the doping concentration of the drift region 18, an average value of doping concentrations in a region where doping concentration distribution is substantially flat may be used.

The buffer region 20 may have two or more concentration peaks in the depth direction (Z axis direction) of the semiconductor substrate 10. The buffer region 20 of the present example is formed by implanting hydrogen ions. The implantation condition of hydrogen ion for the buffer region 20 may be adjusted based on the carbon concentration of the semiconductor substrate 10 estimated by the evaluation method described with reference to Figs. 1 to 9. Accordingly, the donor concentration of the buffer region 20 can be accurately adjusted.

In the transistor portion 70, the collector region 22 of the P+ type is provided below the buffer region 20. An acceptor concentration of the collector region 22 is higher than an acceptor concentration of the base region 14. The collector region 22 may include an acceptor which is the same as or different from an acceptor of the base region 14. The acceptor of the collector region 22 is, for example, boron.

In the diode portion 80, the cathode region 82 of the N+ type is provided below the buffer region 20. A donor concentration of the cathode region 82 is higher than a donor concentration of the drift region 18. A donor of the cathode region 82 is, for example, hydrogen or phosphorous. Note that an element serving as a donor and an acceptor in each region is not limited to the example described above. The collector region 22 and the cathode region 82 are exposed on the lower surface 23 of the semiconductor substrate 10 and are connected to the collector electrode 24. The collector electrode 24 may be in contact with the entire lower surface 23 of the semiconductor substrate 10. The emitter electrode 52 and the collector electrode 24 are formed of a metal material such as aluminum.

One or more gate trench portions 40 and one or more dummy trench portions 30 are provided on the upper surface 21 side of the semiconductor substrate 10. Each trench portion is provided from the upper surface 21 of the semiconductor substrate 10 to a region below the base region 14, penetrating the base region 14. In a region where at least any of the emitter region 12, the contact region 15, or the accumulation region 16 is provided, each trench portion also penetrates the doping regions of these. A configuration in which the trench portion penetrates the doping region is not limited to a configuration which is manufactured by forming the doping region and forming the trench portion in this order. The configuration in which the trench portion penetrates the doping region includes a configuration in which the trench portions are formed and then the doping region is formed between the trench portions.

As described above, the transistor portion 70 is provided with the gate trench portion 40 and the dummy trench portion 30. The diode portion 80 is provided with the dummy trench portion 30 and is not provided with the gate trench portion 40. A boundary in the X axis direction between the diode portion 80 and the transistor portion 70 in the present example is a boundary between the cathode region 82 and the collector region 22.

The gate trench portion 40 includes a gate trench provided in the upper surface 21 of the semiconductor substrate 10, a gate dielectric film 42, and a gate conductive portion 44. The gate dielectric film 42 is provided to cover an inner wall of the gate trench. The gate dielectric film 42 may be formed by oxidizing or nitriding a semiconductor at the inner wall of the gate trench. The gate conductive portion 44 is provided farther inward than the gate dielectric film 42 inside the gate trench. That is, the gate dielectric film 42 insulates the gate conductive portion 44 from the semiconductor substrate 10. The gate conductive portion 44 is formed of a conductive material such as polysilicon.

The gate conductive portion 44 may be provided longer than the base region 14 in the depth direction. The gate trench portion 40 in the cross section is covered with the interlayer dielectric film 38 on the upper surface 21 of the semiconductor substrate 10. The gate conductive portion 44 is electrically connected to the gate runner. When a predetermined gate voltage is applied to the gate conductive portion 44, a channel is formed by an electron inversion layer in a surface layer of the base region 14 at a boundary in contact with the gate trench portion 40.

The dummy trench portion 30 may have a same structure as the gate trench portion 40 in the cross section. The dummy trench portion 30 includes a dummy trench provided in the upper surface 21 of the semiconductor substrate 10, a dummy dielectric film 32, and a dummy conductive portion 34. The dummy conductive portion 34 is electrically connected to the emitter electrode 52. The dummy dielectric film 32 is provided to cover an inner wall of the dummy trench. The dummy conductive portion 34 is provided inside the dummy trench, and is provided farther inward than the dummy dielectric film 32. The dummy dielectric film 32 insulates the dummy conductive portion 34 from the semiconductor substrate 10. The dummy conductive portion 34 may be formed of a same material as the gate conductive portion 44. For example, the dummy conductive portion 34 is formed of a conductive material such as polysilicon. The dummy conductive portion 34 may have a same length as the gate conductive portion 44 in the depth direction.

The gate trench portion 40 and the dummy trench portion 30 of the present example are covered with the interlayer dielectric film 38 on the upper surface 21 of the semiconductor substrate 10. Note that the bottom portions of the dummy trench portion 30 and the gate trench portion 40 may be formed in a curved-surface shape (a curved shape in the cross section) convexly downward.

While the present invention has been described by way of the embodiments, the technical scope of the present invention is not limited to the above-described embodiments. It is apparent to persons skilled in the art that various alterations or improvements can be made to the above-described embodiments. It is also apparent from description of the claims that the embodiments to which such changes or improvements are made may be included in the technical scope of the present invention.

It should be noted that each process of the operations, procedures, steps, stages, and the like performed by the device, system, program, and method shown in the claims, specification, or drawings can be executed in any order as long as the order is not indicated by "prior to", "before", or the like and as long as the output from a previous process is not used in a later process. Even if the operation flow is described using phrases such as "first" or "next" for the sake of convenience in the claims, specification, or drawings, it does not necessarily mean that the process must be performed in this order.

### EXPLANATION OF REFERENCES

10: semiconductor substrate; 12: emitter region; 14: base region; 15: contact region; 16: accumulation region; 18: drift region; 20: buffer region; 21: upper surface; 22: collector region; 23: lower surface; 24: collector electrode; 30: dummy trench portion; 32: dummy dielectric film; 34: dummy conductive portion; 38: interlayer dielectric film; 40: gate trench portion; 42: gate dielectric film; 44: gate conductive portion; 52: emitter electrode; 54: contact hole; 60, 61: mesa portion; 70: transistor portion; 80: diode portion; 82: cathode region; 100: semiconductor device; 202: implantation surface; 301, 302, 303: carrier concentration distribution; 304, 305: sample; 310: correlation information; 311, 312: straight line; 321: first concentration peak; 322: second concentration peak; 323: third concentration peak; 331, 332, 333: portion; and 351, 352: peak.

## Claims

1. An evaluation method of a semiconductor substrate, comprising:
implanting hydrogen ions from an implantation surface of a semiconductor substrate containing silicon;
annealing the semiconductor substrate;
measuring a differential carrier concentration, which is a difference between a first carrier concentration in a passage region of the semiconductor substrate through which the hydrogen ions have passed and a second carrier concentration in a non-passage region of the semiconductor substrate where the hydrogen ions have not reached; and
evaluating a carbon concentration in the semiconductor substrate, based on the differential carrier concentration.

2. The evaluation method of the semiconductor substrate according to claim **1,** wherein
in the implanting the hydrogen ions, the hydrogen ions are implanted into one or more implantation positions of the semiconductor substrate, and
a dose amount of the hydrogen ions for at least one of the implantation positions is 1×10¹¹/cm² or more.

3. The evaluation method of the semiconductor substrate according to claim 1, wherein
in the implanting the hydrogen ions, the hydrogen ions are implanted into a first implantation position and a second implantation position closer to the implantation surface than the first implantation position, and
in measurement of the first carrier concentration, a carrier concentration in a region between the first implantation position and the second implantation position is measured.

4. The evaluation method of the semiconductor substrate according to claim 3, wherein
a dose amount of the hydrogen ions for the first implantation position is identical to a dose amount of the hydrogen ions for the second implantation position.

5. The evaluation method of the semiconductor substrate according to claim 3, wherein
a dose amount of the hydrogen ions for the first implantation position is larger than a dose amount of the hydrogen ions for the second implantation position.

6. The evaluation method of the semiconductor substrate according to claim 3, wherein
a dose amount of the hydrogen ions for the first implantation position is smaller than a dose amount of the hydrogen ions for the second implantation position.

7. The evaluation method of the semiconductor substrate according to any one of claims 3 to 6, wherein
after the annealing, a carrier concentration distribution in a depth direction of the semiconductor substrate has a first concentration peak at the first implantation position, and
a first distance between the first implantation position and the second implantation position is 2 times or more and 10 times or less a first half width at half maximum at a portion of the first concentration peak on a side of the implantation surface.

8. The evaluation method of the semiconductor substrate according to claim 7, wherein
after the annealing, the carrier concentration distribution has a second concentration peak at the second implantation position, and
the first distance is larger than a sum of the first half width at half maximum and a second half width at half maximum at a portion of the second concentration peak on a side opposite to the implantation surface.

9. The evaluation method of the semiconductor substrate according to claim 8, wherein
the second concentration peak is in contact with the implantation surface.

10. The evaluation method of the semiconductor substrate according to claim 1 or 2, wherein
in the implanting the hydrogen ions, the hydrogen ions are implanted into a third implantation position of the semiconductor substrate,
in measurement of the first carrier concentration, a carrier concentration in a region from the implantation surface to the third implantation position is measured, and
in measurement of the second carrier concentration, a carrier concentration in a region farther from the implantation surface than the third implantation position is measured.

11. The evaluation method of the semiconductor substrate according to claim 10, wherein
after the annealing, a carrier concentration distribution in a depth direction of the semiconductor substrate has a third concentration peak at the third implantation position, and
in the measurement of the first carrier concentration, a carrier concentration is measured at a position, which is a third half width at half maximum or more away from the third implantation position, in the passage region between the implantation surface and the third implantation position, the third half width at half maximum being in a portion of the third concentration peak on a side of the implantation surface.

12. The evaluation method of the semiconductor substrate according to claim 11, wherein
in the measurement of the first carrier concentration, a carrier concentration is measured between the third implantation position and a center position between the implantation surface and the third implantation position.

13. The evaluation method of the semiconductor substrate according to claim 12, wherein
a distance between the implantation surface and the center position is 2 times or more the third half width at half maximum.

14. The evaluation method of the semiconductor substrate according to any one of claims 1 to 6, comprising
acquiring correlation information indicating a relationship between a carbon concentration of the semiconductor substrate and the differential carrier concentration, wherein
in the evaluating the carbon concentration, the carbon concentration is calculated from the differential carrier concentration that is measured and the correlation information.

15. The evaluation method of the semiconductor substrate according to claim 1 or 2, wherein
the semiconductor substrate is an MCZ substrate.

16. A manufacturing method of a semiconductor device, comprising:
evaluating a carbon concentration of a semiconductor substrate for evaluation by using the evaluation method of the semiconductor substrate according to claim 1;
determining an implantation condition of ions to be implanted into a semiconductor substrate for manufacturing, based on an evaluation result of the semiconductor substrate for evaluation; and
manufacturing a semiconductor device by using the semiconductor substrate for manufacturing, based on the implantation condition that is determined.
